# FASCICULE DE BREVET EUROPEEN

(11) **EP 4 363 226 B1**
(45) Date de publication et mention de la délivrance du brevet: **11.12.2024**
(21) Numéro de dépôt: 22737862.7
(22) Date de dépôt: 27.06.2022
(51) Int. Cl.: B41C 1/14, B32B 17/10, B41M 1/12, B41M 1/34, B41N 1/24, C03C 17/10, H05B 3/84, B41M 1/22, H05K 3/12, C03C 17/36, H05K 1/03

(54) **ECRAN DE SÉRIGRAPHIE POUR L'OBTENTION DE VITRAGES MUNIS DE MOTIFS ÉLECTROCONDUCTEURS**
SIEBDRUCKSCHABLONE ZUR HERSTELLUNG VON VERGLASUNGSEINHEITEN MIT ELEKTRISCH LEITFÄHIGEN MUSTERN
SCREEN-PRINTING SCREEN FOR OBTAINING GLAZING UNITS PROVIDED WITH ELECTRICALLY CONDUCTIVE PATTERNS

(30) Priorité: 30.06.2021 FR 2107025
(43) Date de publication de la demande: 08.05.2024
(73) Titulaire: Saint-Gobain Glass France, 92400 Courbevoie (FR)
(72) Inventeur: BACHAROUCHE, Jalal, 60280 Clairoix (FR); LEPRETRE, Samuel, 60200 Compiègne (FR)
(74) Mandataire: Saint-Gobain Recherche
(86) Numéro de dépôt international: PCT/EP2022/067487
(87) Numéro de publication internationale: WO 2023/274915

(56) Documents cités:
- WO-A1-2019/206592
- US-A1- 2016 129 685

## Description

La présente invention se rapporte au domaine de l'impression de motifs électroconducteurs, notamment à base d'argent, sur des vitrages.

Des motifs électroconducteurs, tels que des fils chauffants, antennes ou autres capteurs présents dans les vitrages automobiles sont faits à partir d'une pâte conductrice, par exemple une pâte à l'argent sérigraphiée sur une feuille de verre, et sont connectés à un système d'alimentation électrique par l'intermédiaire de connecteurs soudés à la pâte conductrice. Les connecteurs sont soudés dans certaines zones bien définies du vitrage et les alliages utilisés actuellement pour réaliser ces soudures sont des alliages sans plomb, par exemple à base d'argent, d'étain et de cuivre.

Les vitrages équipés de tels dispositifs électroconducteurs doivent, pour pouvoir être mis sur le marché et acceptés par les constructeurs automobiles, passer avec succès des tests de résistance de plus en plus contraignants. Les alliages utilisés pour les soudures doivent notamment répondre aux critères imposés par le test TCT (ou « *température cycling test* »). L'objectif de ce test est de déterminer si le vitrage une fois équipé des fonctions électriques peut résister à des montées et descentes en température successives et rapides, sans être fragilisé. Ces tests ont été mis au point afin d'accélérer les effets qui seraient provoqués par les différences de comportement thermique des différents composants du système. Le nouveau test impose des variations de température entre -40°C et +105°C, donc sur une plage de variation plus importante que les tests précédents qui se limitaient à 90°C. Le nombre de cycles a également été modifié puisqu'il est passé de 10 cycles à un minimum de 60 cycles. Les nouvelles conditions du TCT imposent également que ces variations de température soient effectuées sous une tension de 14 V pendant les phases de montée en température, ce qui entraîne des échauffements supplémentaires et correspond à des températures locales qui peuvent aller approximativement jusqu'à 120°C. Pour passer avec succès ces tests, il s'est révélé nécessaire d'augmenter l'épaisseur des motifs électroconducteurs, notamment dans les zones de soudure, aux endroits où sont placés les connecteurs et où est réalisée la soudure avec l'alliage sans plomb. Dans un vitrage automobile, les zones de connexion ou de soudure se font généralement au niveau des bandes collectrices (encore appelées « bus bars » dans la terminologie anglo-saxonne) situées de part et d'autre du réseau chauffant, dans des parties latérales du vitrage, mais peuvent se faire également dans des parties plus centrales.

On sait imprimer par sérigraphie en une seule étape des motifs électroconducteurs d'épaisseur différente entre la partie centrale et les parties latérales, en utilisant un seul et même tissu (ou tamis) d'impression, dont la taille des mailles est variable selon les zones et permet d'imprimer des motifs d'épaisseur différente. Ces tissus permettent notamment de déposer sur les parties latérales des vitrages des épaisseurs de pâtes plus élevées au niveau des bandes collectrices, tout en gardant dans la partie centrale des pistes électroconductrices peu épaisses et peu visibles. Ainsi, l'épaisseur est suffisamment importante aux endroits où les connexions et soudures sont réalisées, mais suffisamment faible dans la partie centrale pour ne pas gêner la visibilité. Ce type de tissu à taille de mailles variables ne permet toutefois pas d'obtenir de manière simultanée, dans la partie centrale du vitrage, des motifs fins et des motifs plus épais. Or, certains points de soudure, notamment au niveau des boutons d'antenne sont souvent positionnés au centre des réseaux chauffants imprimés, dans les zones inférieures ou supérieures de la partie centrale du vitrage. Pour obtenir un motif électroconducteur d'une épaisseur plus importante au niveau de certaines zones de la partie centrale du vitrage, il est possible de procéder à une double sérigraphie puisque les tamis à taille de maille variable ne permettent d'obtenir de fortes épaisseurs que dans des parties latérales, sur les bords des vitrages. Ainsi, pour obtenir des épaisseurs plus importantes dans la partie centrale des vitrages, on effectue une première passe d'impression par sérigraphie de la pâte électroconductrice, puis la pâte est séchée avant de réaliser une seconde passe d'impression identique à la première au niveau d'un second poste d'impression. Cette technologie nécessite par conséquent de lourds investissements, puisqu'il faut au minimum un dispositif de séchage IR et un deuxième poste d'impression. Dans certains cas, si l'épaisseur requise est encore plus importante, il peut être nécessaire de faire une troisième étape de sérigraphie, avec également un séchage intermédiaire.

On cherche donc à mettre au point un procédé simplifié, moins onéreux, permettant de réaliser des motifs électroconducteurs épais à tout emplacement désiré et en particulier, dans la partie centrale d'un substrat, à distance des bandes collectrices.

Une solution, proposée par la demande WO2018/229449, consiste à utiliser un écran de sérigraphie comprenant un tamis principal et sur une zone, située dans la partie centrale, au moins un tamis secondaire fixé sur une face dudit tamis principal, la maille du tamis secondaire étant plus large que la maille du tamis principal dans ladite partie centrale, et la maille du tamis secondaire formant avec la maille du tamis principal un angle α compris entre 1 et 89°. Un tel écran permet d'obtenir en une seule passe de sérigraphie des vitrages possédant dans leur partie centrale des pistes électroconductrices de faible épaisseur et, au niveau de la zone double tamis, donc également dans la partie centrale du vitrage, des motifs électroconducteurs, par exemple des zones de soudure pour boutons d'antennes, particulièrement épais.

Cette solution n'est toutefois pas dénuée d'inconvénient, en particulier en ce qu'elle ne permet pas d'obtenir en outre une surépaisseur dans certaines zones spécifiques des parties latérales. Elle ne permet en outre pas de régler de manière totalement indépendante l'épaisseur des pistes électroconductrices dans les zones de soudure et dans les autres zones. Il n'est ainsi pas toujours possible d'atteindre les épaisseurs désirées dans les zones de soudure tout en respectant les spécifications en termes de résistance du réseau.

La demande WO2019206592 propose quant à elle d'utiliser pour l'impression dans les zones de soudure, au niveau des bandes collectrices, un écran de sérigraphie présentant dans ces zones des parties obturées sous forme de réseaux de points ou de lignes. La fabrication de l'écran met en oeuvre, dans ces zones, une deuxième enduction par de la résine photoréticulable et une deuxième étape d'insolation, ce qui complexifie le procédé. Il a en outre été observé que la surépaisseur d'enduction était progressivement réduite lors de l'utilisation de l'écran du fait de la pression exercée par le racle. La durée de vie de l'écran est alors diminuée. La demande US2016129685 décrit également un procédé dans lequel une deuxième étape d'insolation permet de créer localement une surépaisseur, plus particulièrement en forme de nid d'abeille.

L'invention a pour but d'obvier à ces inconvénients.

A cet effet, l'invention a pour objet un procédé de fabrication d'un écran de sérigraphie pour l'obtention de vitrages munis de motifs électroconducteurs, comprenant les étapes suivantes :
a) l'enduction d'un tamis par une émulsion photoréticulable, puis
b) le séchage du tamis ainsi enduit, puis
c) l'application d'un film autosupporté photoréticulable sur au moins une zone, dite zone de film, d'une face du tamis enduit, puis
d) l'insolation du tamis enduit afin de réticuler l'émulsion photoréticulable et le ou chaque film autosupporté photoréticulable dans des zones prédéterminées appelées zones de réticulation, les zones de réticulation dans au moins une partie de la ou de chaque zone de film se présentant sous la forme d'un réseau de points ou de lignes, puis
e) le lavage du tamis enduit afin d'éliminer l'émulsion et le ou chaque film autosupporté dans les zones autres que les zones de réticulation.

Un autre objet de l'invention est un écran de sérigraphie, pour l'obtention de vitrages munis de motifs électroconducteurs, notamment obtenu par ce procédé. Cet écran comprend un tamis dont une partie des mailles sont obturées par de la matière photoréticulée dans des zones dites zones de réticulation, ledit tamis comprenant au moins une zone dite zone de film telle que les zones de réticulation situées dans la ou chaque zone de film se présentent sous la forme d'un réseau de points ou de lignes, et l'épaisseur de matière photoréticulée obturant les mailles du tamis est plus élevée dans les zones de réticulation situées dans la ou chaque zone de film que dans les zones de réticulation situées en dehors des zones de film.

Un autre objet de l'invention est un procédé d'obtention d'un vitrage, comprenant une feuille de verre revêtue sur une de ses faces de motifs électroconducteurs présentant dans au moins une zone, dite zone de surépaisseur, une épaisseur plus élevée que dans les autres zones, ledit procédé comprenant l'impression par sérigraphie desdits motifs électroconducteurs en une seule passe, selon les étapes suivantes :
- le positionnement d'un écran de sérigraphie selon l'invention en regard d'une feuille de verre, de façon à ce que la ou chaque zone de film dudit écran de sérigraphie soit en regard d'une zone de la feuille de verre destinée à devenir une zone de surépaisseur, puis
- le dépôt, notamment à l'aide d'un racle, sur l'écran de sérigraphie, d'une pâte électroconductrice, puis
- un traitement thermique de cuisson.

L'invention a enfin pour objet un vitrage obtenu, ou susceptible d'être obtenu, par le procédé précédemment décrit. Ce vitrage comprend une feuille de verre revêtue sur une de ses faces de motifs électroconducteurs présentant dans au moins une zone, dite zone de surépaisseur, une épaisseur plus élevée que dans les autres zones.

L'écran obtenu selon l'invention permet d'obtenir, dans les zones du vitrage correspondant aux zones de film de l'écran, des motifs électroconducteurs plus épais. Le procédé de fabrication de l'écran est en outre simplifié, car il ne nécessite pas une deuxième insolation, et l'écran obtenu est plus durable, car la zone de film (et donc la surépaisseur de matière photoréticulée) étant placée en regard du vitrage lors de la sérigraphie, elle n'est pas susceptible d'être dégradée par le racle.

L'écran permet ainsi notamment d'obtenir un vitrage comprenant des motifs comprenant des pistes électroconductrices de faible épaisseur, par exemple un réseau de fils chauffants (notamment au niveau de la zone caméra), un réseau d'alarme, des antennes ou des bandes collectrices, et des zones de soudure d'épaisseur plus importantes pouvant être situées aussi bien en partie centrale que dans les parties latérales du vitrage, par exemple des zones de soudure pour bouton d'antenne situées dans la partie centrale et des zones de soudure de réseau chauffant situées dans la partie latérale en contact avec les bandes collectrices.

Les zones de surépaisseur ne sont pas nécessairement limitées aux zones de soudure. L'invention permet également, de manière avantageuse, d'épaissir certaines zones des bandes collectrices, notamment à proximité des zones de soudure, en particulier pour éviter un échauffement indésirable.

Le tamis de l'écran peut être en toute matière connue pour la réalisation d'écrans de sérigraphie, par exemple en polyester ou en polyamide.

Un écran de sérigraphie est traditionnellement obtenu par enduction d'une émulsion photoréticulable sur au moins une partie de la surface d'un tamis, séchage du tamis, insolation du tamis afin de réticuler l'émulsion photoréticulable dans des zones prédéterminées, puis lavage et séchage de l'écran.

L'enduction se fait de préférence des deux côtés du tamis, sur toute sa surface.

L'émulsion photoréticulable permet d'obturer sélectivement les mailles du tamis dans les zones soumises à l'insolation, l'étape de lavage servant ensuite à éliminer l'émulsion dans les zones non soumises à l'insolation, donc dans les parties où les mailles doivent rester non obturées et par lesquelles la pâte d'impression doit passer lors de la sérigraphie pour revêtir la feuille de verre et former les motifs électroconducteurs.

Selon l'invention, un film autosupporté photoréticulable est appliqué sur au moins une zone appelée « zone de film » d'une face du tamis. Ce film permet localement d'ajouter une surépaisseur de matière photoréticulable dans des zones précises de l'écran, sur une de ses faces.

Un tel film est couramment appelé « film capillaire » dans la technique. Il se présente généralement sous la forme d'un film d'une émulsion photoréticulable séchée déposée sur une feuille polymérique, notamment de polyester.

L'épaisseur du film autosupporté photoréticulable est de préférence comprise entre 25 et 100 µm, notamment autour de 50 µm.

L'application se fait de préférence après retrait de la feuille de polymérique et humidification du film, de manière à permettre une adhésion satisfaisante du film au tamis enduit et séché. Pour ce faire, il est par exemple possible de tremper le film dans l'eau pendant quelques secondes. Après cette étape d'humidification, la surface du film présente une adhésion suffisante au tamis enduit et séché.

De préférence, l'écran comprend plusieurs zones de film. Ces zones correspondront sur le vitrage aux zones de surépaisseur, donc notamment, mais pas nécessairement uniquement, aux zones de soudure. Des zones de film sont donc de préférence situées au moins dans les parties latérales de l'écran, et de préférence également dans la partie centrale. La surface totale des zones de film occupe de préférence entre 0,1 et 10%, notamment entre 0,5 et 5%, de la surface de l'écran.

L'étape d'insolation est l'étape au cours de laquelle l'émulsion photoréticule, généralement sous l'effet d'un rayonnement ultraviolet. Cette étape est de préférence réalisée en disposant contre l'écran (avantageusement du côté de la face portant le ou les films) une diapositive comprenant un support transparent, typiquement en polyester, revêtu de motifs d'une encre opaque au rayonnement ultraviolet, correspondant aux motifs électroconducteurs à imprimer sur le vitrage, puis à irradier ladite diapositive au moyen d'un rayonnement ultraviolet. L'émulsion n'est donc réticulée et n'obture les mailles du tamis que dans les parties de l'écran, appelées zones de réticulation, situées sous les parties de la diapositive non recouvertes d'encre. Dans les autres parties, l'émulsion n'est pas réticulée et est éliminée lors de l'étape de lavage, laissant les mailles ouvertes, de sorte que la pâte peut les traverser lors de la sérigraphie. On retrouve ainsi sur le vitrage les motifs figurant sur la diapositive.

Selon l'invention, les zones de réticulation dans au moins une partie (notamment dans au moins 50%, ou au moins 75%, voire la totalité) de la ou de chaque zone de film se présentent sous la forme d'un réseau de points ou de lignes. On rappelle que ces zones de réticulation correspondent sur l'écran aux zones où les mailles sont obturées. La diapositive présente donc le même réseau, mais inversé. Dans le cas des zones de film, les mailles sont obturées par la matière provenant à la fois de l'émulsion ajoutée à l'étape d'enduction a) et du film autosupporté appliqué à l'étape c). L'épaisseur de matière photoréticulée obturant les mailles est donc plus importante dans les zones de film que dans les autres zones.

Le réseau de points est notamment constitué de points périodiquement arrangés sous forme de lignes et de colonnes. Le réseau de ligne est notamment constitué de lignes régulièrement espacées.

Les points du réseau de points peuvent être de toute forme. Ils sont de préférence rectangulaires, carrés, elliptiques ou circulaires. Les meilleurs résultats sont obtenus avec des points circulaires.

De préférence, les points du réseau de points présentent une dimension latérale maximale allant de 0,10 à 0,30 mm, ou les lignes du réseau de ligne présentent une largeur allant de 0,10 à 0,40 mm. Dans le cas de points circulaires, la dimension latérale maximale est le diamètre du point circulaire. De préférence, le rapport R1 entre la distance séparant les centres des points du réseau de points (dans une ligne ou une colonne) et la dimension latérale maximale des points est comprise entre 1 et 3, notamment entre 1,5 et 2,5, voire entre 1,9 et 2,1. Dans le cas d'un réseau de lignes, le rapport R2 entre la distance séparant les centres des lignes et la largeur des lignes est compris entre 0,7 et 2,5, notamment entre 0,8 et 1,2. De telles dimensions, très faibles, sont inférieures à la résolution habituelle de la sérigraphie, et sont avantageuses en ce qu'elles ne permettent pas une impression parfaitement conforme : autrement dit, une certaine épaisseur de pâte électroconductrice se dépose même sous les zones de réticulation. A l'oeil nu, l'impression dans la zone de surépaisseur, correspondant à la zone de film sur l'écran, est continue et homogène, et ne présente pas de réseau de points ou de lignes. Seule une observation microscopique permet de révéler une légère texturation, l'épaisseur de pâte déposée étant légèrement plus faible dans les zones correspondant aux zones de réticulation. L'épaisseur globale (ou moyenne) dans la zone de surépaisseur est toutefois plus élevée que dans les autres zones du vitrage.

Selon un mode de réalisation, le tamis possède une taille de maille identique en tout point. On peut par exemple choisir, pour le tamis, 90 fils par cm pour des diamètres de fil de 40 à 48 µm. De manière plus générale, le nombre de fils par cm est de préférence compris entre 43 et 180, notamment entre 77 et 150, et le diamètre des fils est de préférence compris entre 30 et 150 µm, notamment entre 77 et 120 µm.

Selon un autre mode de réalisation, le tamis comprend une partie centrale et au moins une partie latérale, la taille de la maille dans la partie centrale étant plus grande que la taille de la maille dans la au moins une partie latérale. En particulier, le nombre de fils par cm dans la partie centrale est supérieur au nombre de fils par cm dans la au moins une partie latérale, et le diamètre des fils dans la partie centrale est inférieur au diamètre des fils dans la au moins une partie latérale.

Dans le cadre de ce mode de réalisation, on peut avantageusement choisir :
- dans la zone centrale, 77 fils par cm pour un diamètre de 48 µm, 77 fils par cm pour un diamètre de 55 µm, 90 fils par cm pour un diamètre de 48 µm,
- dans la ou chaque zone latérale, 42 fils par cm pour un diamètre de 80 µm, 48 fils par cm pour un diamètre de 80 µm, 49 fils par cm pour un diamètre de 70 µm.

Ce type de tamis permet notamment de déposer une épaisseur plus importante de pâte électroconductrice au niveau des parties latérales, qui correspondent au positionnement des bandes collectrices (ou bus bars), comparativement aux zones d'impression correspondant aux fils plus fins du réseau chauffant. On peut citer comme exemple de ce type de tamis le produit Vario^{®} de SEFAR ou Variant^{®} de SAATI, qui permet lors d'une même impression, d'obtenir différentes épaisseurs dans différentes zones du vitrage.

De préférence, l'écran est rectangulaire ou sensiblement rectangulaire, et la partie centrale correspond à la partie rectangulaire, s'étendant sur toute la longueur des petits côtés de l'écran, dont la médiatrice des petits côtés correspond à la médiatrice des grands côtés de l'écran, et qui occupe 20 à 40% de la surface de l'écran. L'écran comprend de préférence deux parties latérales, correspondant aux deux parties rectangulaires disposées symétriquement par rapport à la médiatrice des grands côtés du rectangle, de part et d'autre de cette dernière, occupant de 20 à 40% de la surface de l'écran.

Les motifs électroconducteurs comprennent de préférence des pistes électroconductrices situées dans au moins une partie latérale et dans une partie centrale du vitrage, les zones de surépaisseur étant situées dans ladite partie centrale et/ou dans au moins une partie latérale. De préférence, les zones de surépaisseur sont situées à la fois dans la partie centrale et dans au moins une partie latérale, et même dans les parties latérales.

Les pistes électroconductrices situées dans la partie centrale sont notamment des fils chauffants, des films d'alarme et/ou des antennes. Les pistes électroconductrices situées dans une partie latérale, notamment dans deux parties latérales opposées, sont notamment des bandes collectrices.

Avantageusement, les zones de surépaisseur englobent des zones de soudure, voire correspondent à des zones de soudure. Les zones de surépaisseur situées dans la partie centrale sont ou englobent par exemple des zones de soudure pour connexion d'antenne ou d'alarme. Les zones de surépaisseur situées dans les parties latérales englobent par exemple des zones de soudure pour connexion d'un réseau chauffant. Ces dernières sont par exemple situées sur chacune des bandes collectrices.

Les zones de soudure sont des zones sur lesquelles un connecteur peut être soudé afin de connecter électriquement les motifs électroconducteurs. Ainsi, lorsque les zones de surépaisseur englobent ou correspondent à des zones de soudure, le procédé peut donc également comprendre une étape supplémentaire de soudure d'au moins un connecteur sur au moins une partie d'une zone de surépaisseur. La soudure est en particulier réalisée à l'aide d'un alliage de soudure.

Le connecteur est de préférence métallique, notamment en acier contenant du chrome. La soudure est réalisée à l'aide d'un alliage de soudure qui est de préférence sans plomb, notamment à base d'étain, d'argent et de cuivre.

La feuille de verre est typiquement en verre sodocalcique, mais peut être en d'autres types de verre, par exemple borosilicate ou aluminosilicate. Son épaisseur est de préférence comprise entre 0,7 et 6 mm, notamment entre 1 et 4 mm. Au moins une dimension de la feuille de verre est de préférence d'au moins 1 m.

La feuille de verre peut être claire, ou de préférence teintée, par exemple en vert, gris ou bleu. Pour ce faire, la composition du verre comprend des colorants, en particulier de l'oxyde de fer, en une teneur pondérale totale (exprimée sous la forme Fe₂O₃) comprise entre 0,05 et 2,1%, notamment entre 0,1 et 1,0%.

La feuille de verre est généralement plane au moment du dépôt des motifs électroconducteurs. Elle est ensuite de préférence bombée, normalement lors du traitement thermique de cuisson des motifs électroconducteurs. Le vitrage final est donc de préférence bombé.

La face de la feuille de verre sur laquelle le dépôt des motifs électroconducteurs est réalisé peut au préalable avoir été revêtue en partie par un revêtement d'émail. En particulier, un revêtement d'émail noir peut avoir été déposé par sérigraphie à la périphérie de la feuille de verre et une partie des motifs électroconducteurs (notamment les bandes collectrices) est alors déposée sur le revêtement d'émail. Dans ce cas, le procédé comprend, avant le dépôt des motifs électroconducteurs, une étape préalable de dépôt par sérigraphie d'un revêtement d'émail noir à la périphérie de la feuille de verre, sur lequel une partie des motifs électroconducteurs est déposée. Un tel revêtement permet de dissimuler et protéger contre le rayonnement ultraviolet les joints servant au positionnement et au montage du vitrage dans la baie de carrosserie. Le revêtement d'émail permet également de dissimuler les bandes collectrices.

L'étape de sérigraphie est réalisée en positionnant l'écran de sérigraphie en regard de la feuille de verre puis en déposant, notamment à l'aide d'un racle, sur l'écran de sérigraphie une pâte électroconductrice, notamment à l'argent. Lors de l'étape de sérigraphie, les zones de film sont disposées en regard des zones de la feuille de verre destinées à devenir des zones de surépaisseur. L'expression « en regard » implique que la face de l'écran où le film autosupporté photoréticulable a été appliqué soit tournée vers la feuille de verre. De la sorte, la zone de film n'est pas endommagée par le racle lors de la sérigraphie.

Les motifs électroconducteurs sont de préférence formés d'une pâte à l'argent.

De préférence, la pâte électroconductrice à l'argent comprend à l'état humide au plus 88%, notamment au plus 85% en poids d'argent, par exemple de 75 à 85%, notamment de 80 à 84% en poids d'argent. Ces pâtes à forte teneur en argent comparativement aux pâtes habituellement employées, sont particulièrement adaptées aux alliages de soudure sans plomb. Ces pâtes d'argent nécessitent, pour assurer une bonne soudabilité et une bonne résistance au test TCT, d'en appliquer de plus fortes épaisseurs dans les zones de soudure, ce qui devient possible grâce au procédé selon la présente invention.

Plus la teneur en argent de la pâte est faible, plus l'épaisseur des motifs (de la première couche) à l'état humide (avant cuisson) doit être importante pour une même épaisseur de motif après cuisson. Ainsi pour une épaisseur de motif de 8 µm après cuisson, l'épaisseur à l'état humide est typiquement de l'ordre de 25 µm pour une pâte contenant 80% en poids d'argent, et de l'ordre de 35 à 40 µm pour une pâte contenant 75% en poids d'argent.

De préférence, la pâte comprend en outre un solvant, un medium organique, destinés à faciliter le dépôt par sérigraphie, et une fritte de verre, qui après fusion fixe les particules d'argent sur la feuille de verre.

L'épaisseur des motifs électroconducteurs dans la ou chaque zone de surépaisseur est de préférence d'au moins 8 µm, notamment comprise entre 10 et 20 µm, voire entre 10 et 15 µm, après l'étape de traitement thermique de cuisson. Une telle épaisseur permet de répondre aux exigences du test TCT.

L'épaisseur des motifs dans les zones autres que les zones de surépaisseur est de préférence d'au plus 8 µm, notamment comprise entre 3 et 7 µm.

Le vitrage peut être séché ou non après l'application de la pâte. Le vitrage subit ensuite un traitement thermique afin de cuire la pâte électroconductrice. Ce traitement thermique est typiquement un traitement de bombage et/ou de trempe du verre. Le bombage peut notamment être réalisé par exemple par gravité (le verre se déformant sous son propre poids) ou par pressage, à des températures allant typiquement de 550 à 720°C.

Le vitrage obtenu est notamment une lunette arrière de véhicule automobile, un vitrage latéral de véhicule automobile ou encore un pare-brise de véhicule automobile.

Les motifs électroconducteurs sont notamment des antennes, des bandes collectrices, des fils d'alarme et/ou des fils chauffants. Les bandes collectrices sont de préférence situées dans les deux parties latérales opposées du vitrage. Les fils chauffants sont de préférence situés majoritairement dans la partie centrale du vitrage, et s'étendent parallèlement au bord long du vitrage entre les deux bandes collectrices. C'est le cas notamment pour une lunette arrière.

De préférence, la ou chaque zone de surépaisseur englobe ou est une zone de soudure pour connexion d'antenne et/ou de réseau chauffant et/ou d'alarme.

Dans le cas d'un pare-brise les motifs électroconducteurs sont notamment des antennes. Les motifs électroconducteurs peuvent aussi être des fils chauffants assurant un chauffage local dans les fenêtres de caméra, par exemple pour la détection de la distance du véhicule frontal.

Dans le cas d'un vitrage latéral, les motifs électroconducteurs sont notamment des antennes ou des fils d'alarme.

L'invention sera mieux comprise à la lumière des exemples de réalisation qui suivent, illustrés par les Figures 1 à 3.
[Fig.1] représente un écran de sérigraphie selon l'invention.
[Fig.2] représente une zone de film.
[Fig.3] représente un vitrage obtenu selon l'invention, dans l'exemple une lunette arrière de véhicule automobile.

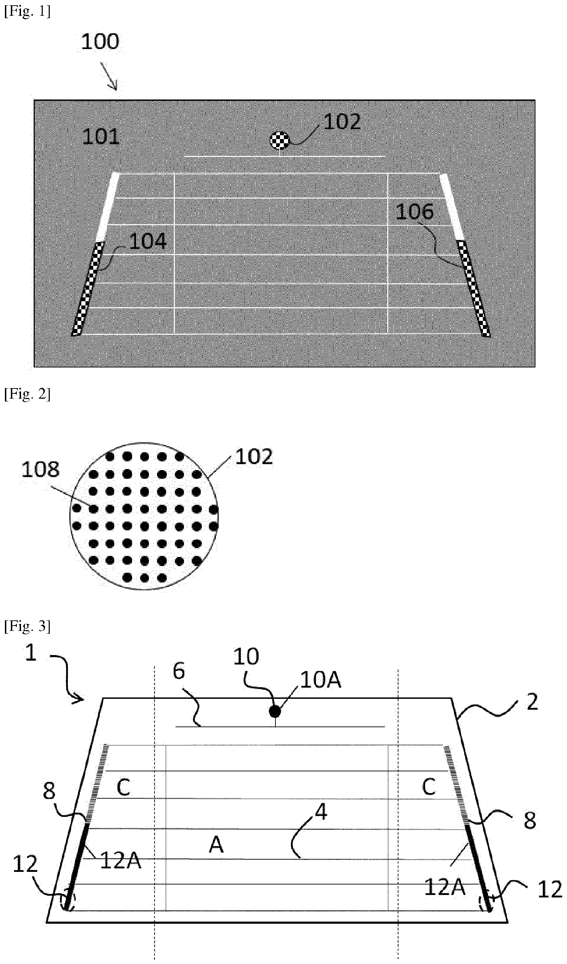

L'écran de sérigraphie 100 schématiquement représenté en [Fig.1] comprend un tamis rectangulaire 101 sur la surface duquel des films autosupportés photoréticulables ont été appliqués dans des zones de film 102, 104 et 106. Les zones du tamis 101 dans lesquelles les mailles sont obturées (zones de réticulation) sont représentées grisées, tandis que les zones dans lesquelles les mailles ne sont pas obturées sont représentées en blanc. Ces zones non-obturées dessinent un motif qui correspondra dans le vitrage final aux zones dans lesquelles les motifs électroconducteurs seront déposés.

La [Fig.2] représente schématiquement une des zones de film, la zone 102. Après l'insolation au moyen d'un rayonnement ultraviolet, la zone de film 102 présente une zone de réticulation, donc une zone où les mailles du tamis sont obturées, schématiquement représentée en noir. Cette zone de réticulation se présente sous la forme d'un réseau de points 108. A titre d'exemple non limitatif, ces points sont ici circulaires et présentent un diamètre de 0,2 mm, la distance séparant les centres des points étant de 0,4 mm. La taille des points est donc volontairement exagérée sur la figure afin de permettre leur visualisation. La zone représentée en blanc correspond aux zones où les mailles du tamis 101 ne sont pas obturées.

La présence de ces zones de film 102, 104 et 106 sur l'écran a permis d'obtenir des zones de surépaisseur sur le vitrage 1 représenté en [Fig.3]. Comme expliqué précédemment, les zones de surépaisseur ont été obtenues en disposant en regard de ces dernières les zones de film de l'écran 100 lors de l'étape de sérigraphie.

Dans cette [Fig.3], le vitrage 1 comprend une feuille de verre 2 possédant une partie centrale A et deux parties latérales C. Dans ces parties A et C ont été imprimés des motifs électroconducteurs 4, 6, 8, 10, plus précisément un réseau de fils chauffants 4 horizontaux et verticaux, reliés dans les parties latérales C à des bandes collectrices 8, une antenne 6, une zone de soudure pour bouton d'antenne 10. Dans chaque partie latérale C les bandes collectrices 8 comprennent une zone de soudure 12 pour l'alimentation du réseau chauffant. La position des zones de soudure 12, dans la partie basse des bandes collectrices 8, est schématisée sur la figure par des traits pointillés.

Les fils 4, 6, les bandes collectrices 8, ainsi que le bouton d'antenne 10 ont été imprimés par sérigraphie d'une pâte à l'argent (comprenant par exemple 80% en poids d'argent) sur la feuille de verre 2.

Certaines zones 10A, 12A, représentées en couleur plus foncée, sont des zones de surépaisseur. La zone 10A est une zone correspondant à une zone de soudure pour connexion de l'antenne 6. Les zones 12A sont des zones situées sur les bandes collectrices 8 et englobent les zones de soudure 12 pour connexion du réseau chauffant.

Dans une étape préalable, un revêtement d'émail noir (non représenté) a été déposé par sérigraphie à la périphérie de la feuille de verre 2, sous forme de bande périphérique. Certains motifs électroconducteurs, en particulier les bandes collectrices 8, ont donc été déposés sur ce revêtement d'émail.

Les motifs électroconducteurs présentent dans les zones de surépaisseur 10A et 12A une épaisseur plus élevée que dans les autres zones.

Les zones de surépaisseur 12A sont ici plus larges que la zone de soudure 12 proprement dite, et donc « débordent » au-delà de cette zone, afin d'éviter un échauffement indésirable dans les zones situées à proximité de la zone de soudure. Dans un autre mode de réalisation, les zones de surépaisseur 12A peuvent correspondre exactement aux zones de soudure 12.

La feuille de verre a ensuite subi un traitement thermique de bombage à une température d'environ 620°C, étape durant laquelle a également été réalisée la cuisson de la première et de la deuxième couche.

Après cuisson, l'épaisseur dans les zones de surépaisseur 10A et 12A était typiquement de l'ordre de 10 à 15 µm. Dans les autres zones l'épaisseur était de 8 µm.

## Revendications

1. Procédé de fabrication d'un écran de sérigraphie (100) pour l'obtention de vitrages munis de motifs électroconducteurs, comprenant les étapes suivantes :
a) l'enduction d'un tamis (101) par une émulsion photoréticulable, puis
b) le séchage du tamis (101) ainsi enduit, puis
c) l'application d'un film autosupporté photoréticulable sur au moins une zone, dite zone de film (102, 104, 106), d'une face du tamis (101) enduit, puis
d) l'insolation du tamis (101) enduit afin de réticuler l'émulsion photoréticulable et le ou chaque film autosupporté photoréticulable dans des zones prédéterminées appelées zones de réticulation, les zones de réticulation dans au moins une partie de la ou de chaque zone de film se présentant sous la forme d'un réseau de points (108) ou de lignes, puis
e) le lavage du tamis enduit afin d'éliminer l'émulsion et le ou chaque film autosupporté dans les zones autres que les zones de réticulation.

2. Procédé selon la revendication précédente, dans lequel des zones de film sont situées au moins dans les parties latérales de l'écran, et de préférence également dans la partie centrale.

3. Procédé selon l'une des revendications précédentes, dans lequel l'épaisseur du film autosupporté photoréticulable est comprise entre 25 et 100 µm.

4. Procédé selon l'une des revendications précédentes, dans lequel les points (108) du réseau de points présentent une dimension latérale maximale allant de 0,10 à 0,30 mm, ou les lignes du réseau de ligne présentent une largeur allant de 0,10 à 0,40 mm.

5. Procédé selon la revendication précédente, dans lequel le rapport R1 entre la distance séparant les centres des points (108) du réseau de points et la dimension latérale maximale des points (108) est comprise entre 1 et 3.

6. Ecran de sérigraphie (100) pour l'obtention de vitrages munis de motifs électroconducteurs obtenu par le procédé selon l'une des revendications précédentes, ledit écran (100) comprenant un tamis (101) dont une partie des mailles sont obturées par de la matière photoréticulée dans des zones dites zones de réticulation, ledit tamis (101) comprenant au moins une zone (102, 104, 106) dite zone de film telle que les zones de réticulation situées dans la ou chaque zone de film se présentent sous la forme d'un réseau de points (108) ou de lignes, et l'épaisseur de matière photoréticulée obturant les mailles du tamis est plus élevée dans les zones de réticulation situées dans la ou chaque zone de film que dans les zones de réticulation situées en dehors des zones de film.

7. Procédé d'obtention d'un vitrage (1) comprenant une feuille de verre (2) revêtue sur une de ses faces de motifs électroconducteurs (4, 6, 8, 10) présentant dans au moins une zone (10A, 12A), dite zone de surépaisseur, une épaisseur plus élevée que dans les autres zones, ledit procédé comprenant l'impression par sérigraphie desdits motifs électroconducteurs en une seule passe, selon les étapes suivantes :
- le positionnement d'un écran de sérigraphie (100) selon la revendication précédente en regard d'une feuille de verre (2), de façon à ce que la ou chaque zone de film (102, 104, 106) dudit écran de sérigraphie soit en regard d'une zone de la feuille de verre (2) destinée à devenir une zone de surépaisseur (10A, 12A), puis
- le dépôt, notamment à l'aide d'un racle, sur l'écran de sérigraphie (100), d'une pâte électroconductrice, puis
- un traitement thermique de cuisson.

8. Procédé selon la revendication précédente, tel que les motifs électroconducteurs (4, 6, 8, 10) comprennent des pistes électroconductrices (4, 6, 8) situées dans au moins une partie latérale (C) et dans une partie centrale du vitrage (A), les zones de surépaisseur (10A, 12A) étant situées dans ladite partie centrale (A) et/ou dans au moins une partie latérale (C), de préférence les zones de surépaisseur (10A, 12A) étant situées dans la partie centrale (A) et dans les parties latérales (C).

9. Procédé selon l'une des revendications 7 ou 8, comprenant, avant le dépôt des motifs électroconducteurs, une étape préalable de dépôt par sérigraphie d'un revêtement d'émail noir à la périphérie de la feuille de verre (2), sur lequel une partie des motifs électroconducteurs (6, 8, 10) est déposée.

10. Procédé selon l'une des revendications 7 à 9, dans lequel les motifs électroconducteurs (4, 6, 8, 10) sont formés d'une pâte à l'argent, notamment comprenant à l'état humide au plus 88% en poids d'argent.

11. Procédé selon l'une des revendications 7 à 10, tel que l'épaisseur des motifs électroconducteurs (8, 10) dans la ou chaque zone de surépaisseur (10A, 12A) est d'au moins 8 µm, notamment comprise entre 10 et 20 µm, et l'épaisseur des motifs (4, 6, 8) dans les zones autres que les zones de surépaisseur est d'au plus 8 µm, notamment comprise entre 3 et 7 µm, après l'étape de traitement thermique de cuisson.

12. Procédé selon l'une des revendications 7 à 11, dans lequel les zones de surépaisseur (10A, 12A) englobent ou correspondent à des zones de soudure (10, 12), et le procédé comprend en outre une étape supplémentaire de soudure d'au moins un connecteur sur au moins une partie d'une zone de surépaisseur (10A, 12A), notamment sur les zones de soudure (10, 12).

13. Procédé selon la revendication précédente, dans lequel le connecteur est métallique, notamment en acier contenant du chrome, et la soudure est réalisée à l'aide d'un alliage de soudure sans plomb, à base d'étain, d'argent et de cuivre.

14. Procédé selon l'une des revendications 7 à 13, dans lequel le vitrage obtenu est une lunette arrière de véhicule automobile, un vitrage latéral de véhicule automobile ou un pare-brise de véhicule automobile, les motifs électroconducteurs étant notamment des antennes (6), des bandes collectrices (8), des fils d'alarme et/ou des fils chauffants (4), et la ou chaque zone de surépaisseur (10A, 12A) englobant ou étant une zone de soudure pour connexion d'antenne (10A) et/ou de réseau chauffant (12A) et/ou d'alarme.

15. Vitrage (1) obtenu par le procédé de l'une des revendications 7 à 14, ledit vitrage comprenant une feuille de verre (2) revêtue sur une de ses faces de motifs électroconducteurs (4, 6, 8, 10) présentant dans au moins une zone (10A, 12A), dite zone de surépaisseur, une épaisseur plus élevée que dans les autres zones.

## Patentansprüche

1. Verfahren zum Herstellen eines Siebdruckschirms (100) für die Erhaltung von Verglasungen, die mit elektrisch leitenden Mustern versehen sind, umfassend die folgenden Schritte:
a) Beschichten eines Siebs (101) mit einer photovernetzbaren Emulsion, dann
b) Trocknen des so beschichteten Siebs (101), dann
c) Auftragen einer photovernetzbaren, selbsttragenden Folie auf mindestens einen Bereich, der als Folienbereich (102, 104, 106) bezeichnet wird, einer Seite des beschichteten Siebs (101), dann
d) Belichten des beschichteten Siebs (101), um die photovernetzbare Emulsion und die oder jede photovernetzbare selbsttragende Folie in zuvor bestimmten Bereichen, die Vernetzungsbereiche genannt werden, zu vernetzen, wobei die Vernetzungsbereiche in mindestens einem Teil des oder jedes Folienbereichs die Form eines Netzes von Punkten (108) oder Linien aufweisen, dann
e) Waschen des beschichteten Siebs, um die Emulsion und die oder jede selbsttragende Folie in anderen Bereichen als den Vernetzungsbereichen zu entfernen.

2. Verfahren nach dem vorstehenden Anspruch, wobei sich Folienbereiche mindestens in den seitlichen Teilen des Schirms, und vorzugsweise ebenfalls in dem mittleren Teil befinden.

3. Verfahren nach einem der vorstehenden Ansprüche, wobei die Dicke der selbsttragenden, photovernetzbaren Folie zwischen 25 und 100 µm liegt.

4. Verfahren nach einem der vorstehenden Ansprüche, wobei die Punkte (108) des Netzes von Punkten eine maximale seitliche Abmessung von 0,10 bis 0,30 mm aufweisen oder die Linien des Netzes von Linien eine Breite von 0,10 bis 0,40 mm aufweisen.

5. Verfahren nach dem vorstehenden Anspruch, wobei das Verhältnis R1 zwischen dem Abstand, der die Mitten der Punkte (108) des Netzes von Punkten trennt, und der maximalen seitlichen Abmessung der Punkte (108) zwischen 1 und 3 liegt.

6. Siebdruckschirm (100) für die Erhaltung von Verglasungen, die mit elektrisch leitenden Mustern versehen sind, die durch das Verfahren nach einem der vorstehenden Ansprüche erhalten werden, der Schirm (100) umfassend ein Sieb (101), wobei ein Teil von Maschen durch photovernetzbares Material in Bereichen, die als Vernetzungsbereiche bezeichnet werden, gefüllt sind, das Sieb (101) umfassend mindestens einen Bereich (102, 104, 106), der als Folienbereich bezeichnet wird, wobei die Vernetzungsbereiche, die sich in dem oder in jedem Folienbereich befinden, die Form eines Netzes von Punkten (108) oder Linien aufweisen, und die Dicke des photovernetzbaren Materials, das die Maschen des Siebs füllt, in den Vernetzungsbereichen, die sich in dem oder jedem Folienbereich befinden, größer als in den Vernetzungsbereichen ist, die außerhalb der Folienbereiche liegen.

7. Verfahren zum Erhalten einer Verglasung (1), umfassend eine Glasscheibe (2), die auf einer ihrer Seiten mit elektrisch leitenden Mustern (4, 6, 8, 10) überzogen ist, die in mindestens einem Bereich (10A, 12A), der als Überdickenbereich bezeichnet wird, eine Dicke, die größer als in den anderen Bereichen ist, aufweisen, das Verfahren umfassend das Siebdrucken der elektrisch leitenden Muster in einem einzigen Durchgang gemäß den folgenden Schritten:
- Positionieren eines Siebdruckschirms (100) nach dem vorstehenden Anspruch gegenüber einer Glasscheibe (2), auf eine Weise, dass der oder jeder Folienbereich (102, 104, 106) des Siebdruckschirms einem Bereich der Glasscheibe (2) gegenüber liegt, der dafür bestimmt ist, ein Überdickenbereich (10A, 12A) zu werden, dann
- Aufbringen, insbesondere mittels einer Rakel, auf den Siebdruckschirm (100), einer elektrisch leitfähigen Paste, dann
- Wärmebehandeln zum Einbrennen.

8. Verfahren nach dem vorstehenden Anspruch, wobei die elektrisch leitenden Muster (4, 6, 8, 10) elektrisch leitende Bahnen (4, 6, 8) umfassen, die sich in mindestens einem seitlichen Teil (C) und in einem mittleren Teil der Verglasung (A) befinden, wobei sich die Überdickenbereiche (10A, 12A) in dem mittleren Teil (A) und/oder in mindestens einem seitlichen Teil (C) befinden, vorzugsweise wobei sich die Überdickenbereiche (10A, 12A) in dem mittleren Teil (A) und in den seitlichen Teilen (C) befinden.

9. Verfahren nach einem der Ansprüche 7 oder 8, umfassend vor dem Aufbringen der elektrisch leitenden Muster einen vorherigen Schritt des Aufbringens durch Siebdruck eines schwarzen Emailüberzugs auf den Umfang der Glasscheibe (2), auf den ein Teil der elektrisch leitenden Muster (6, 8, 10) aufgebracht ist.

10. Verfahren nach einem der Ansprüche 7 bis 9, wobei die elektrisch leitenden Muster (4, 6, 8, 10) aus einer Silberpaste ausgebildet werden, insbesondere umfassend in dem nassen Zustand höchstens zu 88 Gew.-% Silber.

11. Verfahren nach einem der Ansprüche 7 bis 10, wobei die Dicke der elektrisch leitenden Muster (8, 10) in dem oder jedem Überdickenbereich (10A, 12A) mindestens 8 µm beträgt, insbesondere zwischen 10 und 20 µm liegt und die Dicke der Muster (4, 6, 8) in den anderen Bereichen außer den Überdickenbereichen höchstens 8 µm beträgt, insbesondere zwischen 3 und 7 µm liegt, nach dem Schritt des Wärmebehandelns zum Einbrennen.

12. Verfahren nach einem der Ansprüche 7 bis 11, wobei die Überdickenbereiche (10A, 12A) Schweißbereiche (10, 12) einschließen oder diesen entsprechen, und das Verfahren ferner einen zusätzlichen Schritt des Schweißens von mindestens einem Verbinder auf mindestens einen Teil des Überdickenbereichs (10A, 12A), insbesondere auf die Schweißbereiche (10, 12), umfasst.

13. Verfahren nach dem vorstehenden Anspruch, wobei der Verbinder metallisch, insbesondere chromhaltiger Stahl, ist und das Schweißen mittels einer bleifreien Schweißlegierung, basierend auf Zinn, Silber und Kupfer, ausgeführt wird.

14. Verfahren nach einem der Ansprüche 7 bis 13, wobei die erhaltene Verglasung eine Heckscheibe eines Kraftfahrzeugs, eine seitliche Verglasung eines Kraftfahrzeugs oder eine Windschutzscheibe eines Kraftfahrzeugs ist, wobei die elektrisch leitenden Mustern insbesondere Antennen (6), Kollektorstreifen (8), Alarmdrähte und/oder Heizdrähte (4) sind, und der oder jeder Überdickenbereich (10A, 12A) ein Schweißbereich für den Antennenanschluss (10A) und/oder das Heiznetzwerk (12A) und/oder den Alarm ist oder diese einschließt.

15. Verglasung (1), die durch das Verfahren nach einem der Ansprüche 7 bis 14 erhalten wird, die Verglasung umfassend eine Glasscheibe (2), die auf einer ihrer Flächen mit elektrisch leitenden Mustern (4, 6, 8, 10) überzogen ist, die mindestens einen Bereich (10A, 12A), der als Überdickenbereich bezeichnet wird, eine größere Dicke als in den anderen Bereichen aufweisen.

## Claims

1. A method of manufacturing a screenprinting screen (100) for obtaining glazings provided with electroconductive patterns, comprising the following steps:
a) coating a mesh (101) with a photocrosslinkable emulsion, then
b) drying the mesh (101) thus coated, then
c) applying a self-supported photocrosslinkable film on at least one area, called film area (102, 104, 106), on one face of the coated mesh (101), then
d) insolating the coated mesh (101) in order to cross-link the photocrosslinkable emulsion and the, or each, self-supported photocrosslinkable film in predetermined areas called cross-linking areas, the cross-linking areas in at least a portion of the, or each, film zone being in the form of a network of points (108) or lines, then
e) washing the coated mesh to eliminate the emulsion and the, or each, self-supported film in the areas other than the cross-linking areas.

2. The method according to the preceding claim, wherein the film areas are located at least in the lateral portions of the screen, and also preferably in the central portion.

3. The method according to one of the preceding claims, wherein the thickness of the self-supported photocrosslinkable film is between 25 and 100 µm.

4. The method according to one of the preceding claims, wherein the points (108) of the points network have a maximum lateral dimension ranging from 0.10 to 0.30 mm, or the lines of the line network have a width ranging from 0.10 to 0.40 mm.

5. The method according to the preceding claim, wherein the ratio R1 between the distance separating the centers of the points (108) of the points network and the maximum lateral dimension of the points (108) falls between 1 and 3.

6. A screenprinting screen (100) for obtaining glazings provided with electroconductive patterns obtained by the method according to one of the preceding claims, said screen (100) comprising a mesh (101) a portion of the apertures of which are blocked by photocrosslinked material in areas called cross-linking areas, said mesh (101) comprising at least one area (102, 104, 106) called film area such that the cross-linking areas located in the, or each, film area are in the form of a network of points (108) or lines, and the thickness of photocrosslinked material blocking the apertures of the mesh is greater in the cross-linking areas located in the, or each, film area than in the cross-linking areas located outside the film areas.

7. A method of obtaining a glazing (1) comprising a sheet of glass (2) coated on one face thereof with electroconductive patterns (4, 6, 8, 10) having in at least one area (1 0A, 12A), called extra thickness area, a greater thickness than in the other areas, said method comprising the screen-printing of said electroconductive patterns in a single run, according to the following steps:
- positioning a screenprinting screen (100) according to the preceding claim facing a glass sheet (2), in such a way that the, or each, film area (102, 104, 106) of said screenprinting screen is facing an area of the glass sheet (2) intended to become an extra thickness area (10A, 12A), then
- depositing, particularly by means of a squeegee, on the screenprinting screen (100), an electroconductive paste, then
- firing heat treating.

8. The method according to the preceding claim, wherein the electroconductive patterns (4, 6, 8, 10) comprise electroconductive tracks (4, 6, 8) located in at least one lateral portion (C) and in a central portion of the glazing (A), with the extra thickness areas (10A, 12A) being located in said central portion (A) and/or in at least one lateral portion (C), the extra thickness areas (10A, 12A) preferably being located in the central portion (A) and in the lateral portions (C).

9. The method according to one of claims 7 or 8, comprising, before the deposition of the electroconductive patterns, a prior step of depositing by screenprinting a black enamel coating at the edge of the glass sheet (2), on which part of the electroconductive patterns (6, 8, 10) is deposited.

10. The method according to one of claims 7 to 9, wherein the electroconductive patterns (4, 6, 8, 10) are formed from a silver paste, particularly comprising, in the wet state, at most 88% by weight of silver.

11. The method according to one of claims 7 to 10, wherein the thickness of the electroconductive patterns (8, 10) in the, or each, extra thickness area (10A, 12A) is at least 8 µm, in particular between 10 and 20 µm, and the thickness of the patterns (4, 6, 8) in the areas other than the extra thickness areas is at most 8 µm, particularly between 3 and 7 µm, after the firing heat treatment step.

12. The method according to one of claims 7 to 11, wherein the extra thickness areas (10A, 12A) encompass or correspond to soldering areas (10, 12), and the method further comprises an additional step of soldering at least one connector to at least part of an extra thickness area (10A, 12A), particularly on the soldering areas (10, 12).

13. The method according to the preceding claim, wherein the connector is metallic, in particular made of steel containing chrome, and the soldering is carried out using a lead-free, tin-based, silver-based and copper-based soldering alloy.

14. The method according to one of claims 7 to 13, wherein the glazing obtained is a rear window of a motor vehicle, a side glazing of a motor vehicle or a windscreen of a motor vehicle, with the electroconductive patterns notably being antennas (6), bus bars (8), alarm wires and/or heating wires (4), and the, or each, extra thickness area (10A, 12A) encompassing or being a soldering area for connecting an antenna (10A) and/or a heating network (12A) and/or an alarm network.

15. A glazing (1) obtained by the method of one of claims 7 to 14, said glazing comprising a glass sheet (2) covered with electroconductive patterns (4, 6, 8, 10) on one of its faces and having in at least one area (10A, 12A), the so-called extra thickness area, a greater thickness than in the other areas.
